# FASCICULE DE BREVET EUROPEEN

(11) **EP 0 583 203 B1**
(45) Date de publication et mention de la délivrance du brevet: **27.11.1996**
(21) Numéro de dépôt: 93420337.3
(22) Date de dépôt: 10.08.1993
(51) Int. Cl.: H03K 19/017, G11C 7/00, H04L 25/08

(54) **Circuit de tirage vers un état déterminé d'une entrée de circuit intégré**
Schaltung zum Ziehen des Eingangs einer integrierten Schaltung auf einen definierten Zustand
Circuit that pulls the input of an integrated circuit into a defined state

(30) Priorité: 12.08.1992 FR 9210140
(43) Date de publication de la demande: 16.02.1994
(73) Titulaire: SGS-THOMSON MICROELECTRONICS S.A., 94250 Gentilly (FR)
(72) Inventeur: Fensch, Thierry, F-38000 Grenoble (FR)
(74) Mandataire: de Beaumont, Michel

(56) Documents cités:
- EP-A- 0 116 762
- WO-A-86/01658
- US-A- 4 498 021
- US-I- T 952 012

## Description

La présente invention concerne les circuits intégrés et plus particulièrement les circuits intégrés logiques en technologie MOS.

Un circuit intégré canprend de nombreux canposants internes et des plots d'accès dont chacun est destiné à émettre et/ou à recevoir des niveaux logiques et/ou analogiques. On s'intéressera plus particulièrement aux plots d'entrée susceptibles de recevoir des niveaux logiques, bien que ces mêmes plots puissent également fonctionner en plots de sortie en fonction d'une sélection entre un amplificateur d'entrée et un amplificateur de sortie.

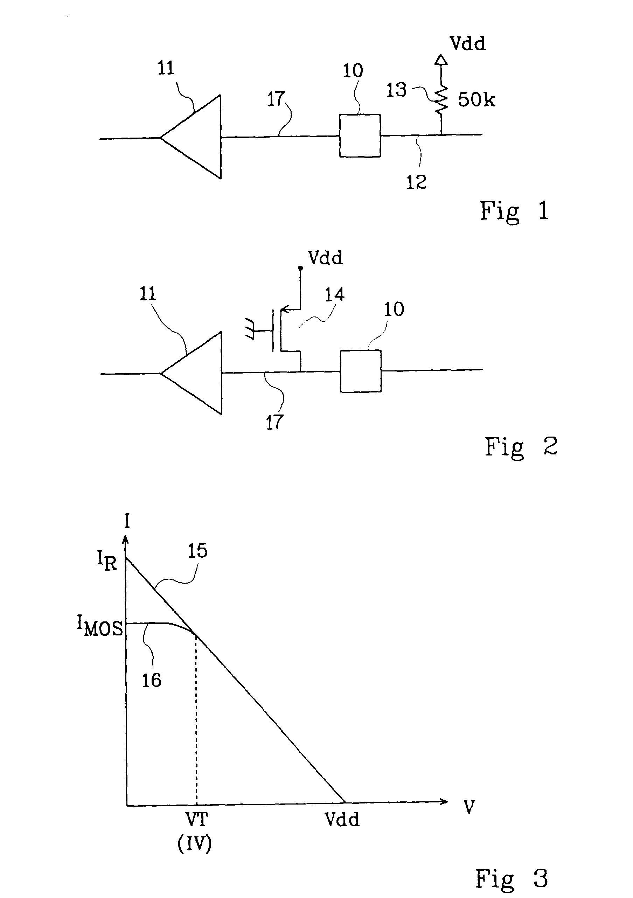

La figure 1 représente très schématiquement un tel plot d'entrée 10 relié par une métallisation à une entrée d'un amplificateur 11 faisant partie d'un circuit intégré. Ce plot est destiné à recevoir de l'extérieur des signaux logiques, c'est-à-dire des tensions à un niveau déterminé haut ou bas. En outre, chaque plot est généralement associé à des composants de protection contre des surcharges, par exemple des décharges électrostatiques. Ces composants de protection n'ont pas été représentés par souci de clarté et de simplicité.

Le plot 10 est relié à l'extérieur du circuit intégré par un conducteur 12. Comme on l'a indiqué précédemment, ce conducteur 12 est normalement placé à un potentiel haut ou à un potentiel bas. Il se produit toutefois de nombreuses situations où ce conducteur est à un potentiel flottant. L'amplificateur d'entrée 11 risque alors de considérer ce niveau flottant tantôt comme un niveau bas tantôt comme un niveau haut. De plus, des parasites ou des décharges électrostatiques survenant sur le conducteur 12 modifieront le potentiel du plot et seront considérés par l'amplificateur 11 comme un changement d'état d'entrée. C'est ce qu'il faut éviter.

Ainsi, les utilisateurs de circuits intégrés logiques prévoient habituellement des moyens pour fixer le potentiel des entrées logiques à un niveau de repos déterminé quand l'entrée est flottante. Dans toute la présente description, on considérera que ce niveau de repos déterminé est le niveau haut. Mais, bien entendu, l'invention pourrait simplement être adaptée par l'homme de métier au cas où ce niveau de repos déterminé est le niveau bas.

De façon classique, les utilisateurs de circuits intégrés logiques placent à l'extérieur du circuit d'entrée, une résistance 13 dite résistance de tirage entre le conducteur d'entrée 12 et la tension Vdd correspondant au niveau haut. Cette résistance doit être suffisamment élevée pour ne pas entraîner une consommation excessive quand le conducteur 12 est placé au niveau bas et doit être suffisamment faible pour que la constante de temps d'élimination d'un parasite tandis que le conducteur 12 est flottant soit suffisamment brève. Une valeur de compromis couramment adoptée est de l'ordre de 50 kohms. Mais il s'agit là d'une valeur de compromis qui n'est pas parfaitement satisfaisante.

En outre, le seul fait de prévoir une résistance de tirage externe au circuit intégré complique les montages que doit faire l'utilisateur de ce circuit intégré.

Le document US-I-T 952012 décrit un circuit de tirage, dans lequel un transistor MOS du type p est connecté entre l'entrée du circuit intégré et un potential haut. Entre le potential haut et un potential bas sont connectés en série un deuxième transistor MOS à canal du type p et un troisième transistor MOS à canal du type n. Les grilles des deuxième et troisième transistors et l'entrée sont connectées entre elles. La grille du premier transistor est connectée au point de raccordement des deuxième et troisième transistors.

Un premier objet de la présente invention est de prévoir un circuit de tirage vers un niveau de repos déterminé d'un plot d'entrée de signal logique de circuit intégré qui soit intégré dans ce circuit.

Un autre objet de la présente invention est de prévoir un tel circuit de tirage qui présente une impédance forte quand le niveau autre que le niveau de repos déterminé est appliqué sur l'entrée tout en ayant une constante de temps faible de mise au niveau de repos quand l'entrée est flottante.

Pour atteindre ces objets, la présente invention prévoit un circuit de tirage vers un deuxième état d'une entrée d'un circuit intégré raccordé au circuit de tirage, le circuit intégré étant susceptible d'être dans un premier état correspondant à un premier potentiel (Vss) sur l'entrée, dans un deuxième état correspondant à un deuxième potentiel (Vdd) sur l'entrée ou dans un troisième état correspondant à un potentiel flottant sur l'entrée, le circuit de tirage comprenant un premier transistor MOS à canal d'un premier type de conductivité dont le trajet drain-source est connecté entre l'entrée et le deuxième potentiel, la connexion en série des trajets drain-source d'un deuxième et d'un troisième transistor MOS à canal du premier type de conductivité et d'un quatrième transistor MOS à canal du deuxième type de conductivité dans cet ordre entre le deuxième potentiel et le premier potentiel, une connexion entre les grilles des premier et deuxième transistors et le point de raccordement des trajets drain-source des troisième et quatrième transistors, et une connexion entre l'entrée et les grilles des troisième et quatrième transistors.

Selon un mode de réalisation de la présente invention, le quatrième transistor est constitué de façon à avoir une résistance à l'état passant élevée par rapport à la résistance à l'état passant des autres transistors.

Selon un mode de réalisation de la présente invention, les premier, deuxième et troisième transistors sont des transistors MOS à canal P et le quatrième transistor est un transistor MOS à canal N, le premier potentiel étant un potentiel bas (Vss) et le deuxième potentiel un potentiel haut (Vdd).

Selon un mode de réalisation de la présente invention, les premier et deuxième transistors sont identiques.

Ces objets, caractéristiques et avantages ainsi que d'autres de la présente invention seront exposés en détail dans la description suivante de modes de réalisation particuliers faite en relation avec les figures jointes parmi lesquelles :
la figure 1 représente un plot d'entrée de circuit intégré associé à une résistance de tirage selon l'art antérieur ; la figure 2 représente un composant de tirage intégré associé à un plot d'entrée ;
la figure 3 représente la courbe caractéristique courant-tension d'un circuit comprenant le composant de tirage de la figure 1 ou de la figure 2 ;
la figure 4 représente un circuit de tirage selon la présente invention ;
la figure 5 représente une portion d'une courbe caractéristique courant-tension d'un circuit de tirage selon la présente invention ; et
la figure 6 représente une courbe caractéristique courant-tension d'un circuit de tirage selon la présente invention.

Etant donné l'état de la technique décrit précédemment en relation avec la figure 1, les utilisateurs de circuit intégré ont demandé aux fabricants de circuit intégré de prévoir une intégration d'un composant de tirage vers le haut tel que la résistance 13.

Une première idée qui pourrait venir à l'homme de métier du domaine des circuits intégrés pour atteindre ce résultat consisterait, comme cela est représenté en figure 2, à relier le plot à la source d'alimentation haute Vdd du circuit par l'intermédiaire d'un transistor MOS à canal P 14 dont la grille est à la masse. En effet, il est usuel dans le domaine des circuits intégrés de remplacer une résistance dont la réalisation amène à l'occupation d'une surface de silicium relativement importante par un transistor MOS. En outre, l'homme de métier choisira les dimensions du transistor MOS, c'est-à-dire essentiellement le rapport W/L entre la largeur et la longueur de grille pour obtenir une valeur de résistance souhaitée (rappelons que l'on appelle habituellement longueur de grille la distance entre source et drain et largeur de grille l'étendue transversale des régions en regard de source et de drain).

En outre, le remplacement d'une résistance par un transistor MOS améliore les caractéristiques de consommation.

La figure 3 représente sur un même graphique la courbe caractéristique tension-courant pour une résistanoe (courbe 15) et pour un transistor MOS (courbe 16). La courbe 15 montre une caractéristique classique linéaire d'une résistance. Quand le plot 10 est à la tension Vdd, le courant est nul. Quand une tension basse, Vss, est imposée sur le plot 10, la consommation de courant dans la résistance est I_{R}=Vdd/R. Par contre, si on utilise un transistor MOS, dès que la tension sur le plot devient inférieure à la tension de seuil VT (habituellement environ 1 volt) de ce MOS, la valeur du courant se sature. Il y a donc une consommation qui est environ 1/5 plus faible dans le cas de l'utilisation d'un transistor MOS si Vdd et Vss ont les valeurs classiques +5 V et 0 volt. Ceci signifie néanmoins que l'on doit choisir la valeur de la résistance à l'état passant du transistor MOS 14 sensiblement égale à la valeur que l'on choisissait pour la résistance 13 et qu'il n'y a pas d'amélioration très importante de la consommation de courant.

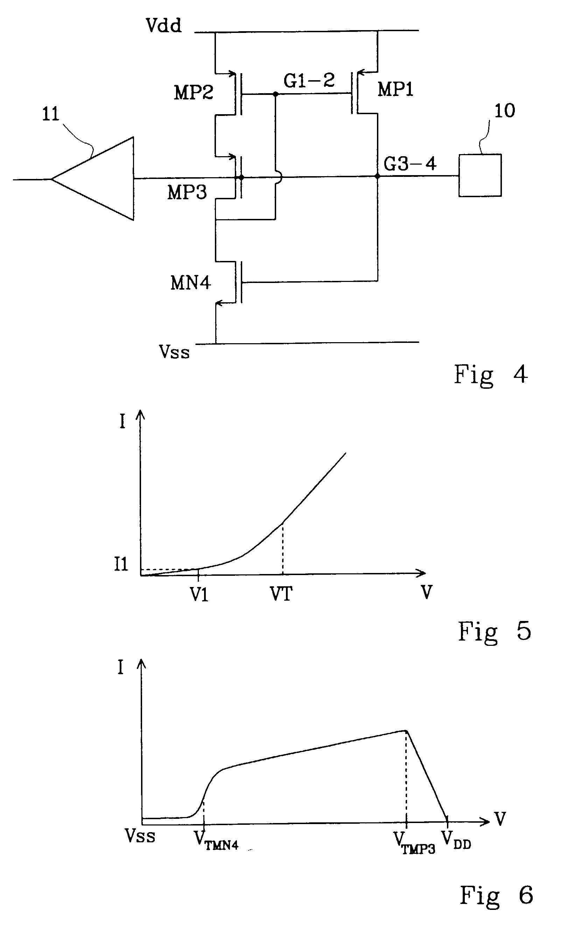

La figure 4 représente le schéma d'un circuit selon la présente invention qui permet de réduire la consommation de courant du transistor de tirage vers le niveau haut quand le plot est au niveau bas (Vss ou O V).

Selon la présente invention, le plot 10 est relié à la source de tension haute par l'intermédiaire d'un transistor MOS à canal P MP1. Par ailleurs, la source de tension haute Vdd (par exemple 5 V) est reliée à la source de tension basse Vss (par exemple 0 V) par l'intermédiaire de la connexion en série de deux transistors MOS à canal P MP2 et MP3 et d'un transistor MOS à canal N MN4. Les grilles des transistors MP2 et MP3 sont interconnectées et leur point de connexion G3-4 est relié au plot 10 (et à l'entrée de l'amplificateur d'entrée 11 du circuit intégré). Les grilles des transistors MP1 et MP2 sont interconnectées et leur point de connexion G1-2 est relié au point de raccordement des troisième et quatrième transistors MP3 et MP4.

Dans une technologie de fabrication où les transistors MOS à canal P sont réalisés dans des caissons N formés dans un substrat P, la prise caisson de chacun de ces caissons sera de préférence reliée au potentiel Vdd.

On va maintenant décrire le fonctionnement du circuit de la figure 4 dans les différents cas de connexion du plot 10.

Quand le plot 10 est relié, par l'extérieur, à un potentiel bas (Vss), le transistor MN4 est à l'état bloqué et le transistor MP3 est à l'état passant. Ainsi, le transistor MP2 peut être considéré comme ayant sa grille reliée à son drain, c'est-à-dire qu'il se comporte comme une diode en série avec le transistor MN4 et il passe dans ce transistor MP2 un très faible courant, qui sera par exemple de l'ordre de 1 nA. Le transistor MP1 ayant sa grille au même potentiel que le transistor MP2 sera sujet à une circulation de courant sensiblement identique, c'est-à-dire qu'il se trouve dans un état de très faible inversion, tel que désigné par les valeurs de courant 11 et V1 dans la portion de courbe caractéristique de la figure 5 où VT désigne la tension de seuil du transistor MP1. L'état susmentionné se maintient tant que la tension sur la borne 10 reste comprise entre Vss et Vss+VTMP2 où VTMP2 désigne la tension de seuil du transistor MOS MP2, couramment de l'ordre de 0,8 V.

Conformément à l'objet de la présente invention, la consommation de courant dans cet état où le plot est au niveau bas est très faible, de l'ordre du nanoampère, alors qu'elle était de l'ordre de 0,1 mA (5V/50kohms) selon l'art antérieur.

Si à partir de cet état de mise à tension basse du plot 10, on laisse flottant le potentiel du plot, le courant de faible inversion dans le transistor MP1 charge la capacité de grille du transistor MN4. Quand le potentiel sur la grille du transistor MN4 dépasse la tension de seuil de ce transistor, celui-ci devient passant, abaissant la tension de grille du transistor MP2 qui devient alors également passant (le transistor MP3 est quant à lui toujours à l'état passant). Le transistor MP1 qui a la même tension de grille que le transistor MP2 devient aussi passant, confirmant l'état conducteur du transistor MN4. La tension du plot 10 est alors tirée vers la valeur Vdd par la mise en conduction du transistor MP1. Quand la tension sur le plot et sur la grille du transistor MP3 s'est élevée jusqu'à une valeur Vdd-VTMP3, le transistor MP3 se bloque. A ce moment, la grille du transistor MP1 est au potentiel Vss du fait de l'état conducteur du transistor MN4. La conduction du transistor MP1 est donc confirmée et celui-ci est dans un état conducteur avec une faible résistance dynamique correspondant à la résistance à l'état passant d'un transistor MOS à canal P, classiquement de 5 à 10 kohms. En raison de cette faible valeur d'impédance, le plot est très bien protégé par rapport aux parasites qui seront éliminés avec une courte constante de temps.

Si le plot passe de son état flottant à un état où sa tension est fixée à 5 V, on demeure dans le même état que celui atteint précédemment avec toujours une consommation pratiquement nulle du circuit.

Si ensuite le plot est ramené à Vss, on revient à l'état décrit précédemment, le transistor MN4 passant rapidement de l'état passant à l'état bloqué.

On a donc réalisé un circuit conforme aux objets de la présente invention à savoir qu'il permet une réalisation simple sous forme de circuit intégré, qu'il présente une faible impédance quand l'entrée est flottante, ce qui améliore la capacité d'élimination des parasites, et qu'il présente une consommation pratiquement nulle quand le plot est dans l'état autre que l'état de repos.

La figure 6 représente la caractéristique courant-tension du circuit de tirage selon la présente invention. Les seules phases de consommation du circuit sont les phases transitoires entre l'état où l'entrée est au niveau bas et l'état où l'entrée devient flottante ainsi que entre les états haut et bas de l'entrée. On a alors une brève phase, essentiellement entre les tensions VTMN4 et VTMP3 où les transistors MP2, MP3 et MN4 sont conducteurs. L'homme de l'art saura choisir les caractéristiques géométriques du transistor MN4 pour limiter ce courant transitoire. A titre d'exemple, on pourra choisir pour les transistors MP1 et MP2 un rapport W/L=10/5, pour le transistor MP3 agissant en interrupteur un rapport W/L=3/2, et pour le transistor MN1 permettant de satisfaire à une caractéristique de limitation de courant un rapport W/L=3/25 (les valeurs numériques indiquées peuvent, dans un mode de réalisation, être des valeurs en micromètres).

On a présenté précédemment les transistors MP1 et MP2 comme identiques. En fonction de caractéristiques particulières, l'homme de métier pourra choisir des rapports géométriques distincts pour ces transistors.

Par ailleurs, comme cela a été indiqué en préambule de la présente description, le circuit selon la présente invention s'appliquerait de même au tirage vers un niveau bas d'un plot. Il faudrait alors inverser le rôle des sources Vdd et Vss et tous les types de transistors MOS décrits.

## Revendications

1. Circuit de tirage vers un deuxième état d'une entrée (10) d'un circuit intégré raccordé au circuit de tirage, le circuit intégré étant susceptible d'être dans un premier état correspondant à un premier potentiel (Vss) sur l'entrée, dans un deuxième état correspondant à un deuxième potentiel (Vdd) sur l'entrée ou dans un troisième état correspondant à un potentiel flottant sur l'entrée, le circuit de tirage comprenant
un premier transistor MOS (MP1) à canal d'un premier type de conductivité dont le trajet drain-source est connecté entre ladite entrée et le deuxième potentiel,
la connexion en série des trajets drain-source d'un deuxième (MP2) et d'un troisième (MP3) transistor MOS à canal du premier type de conductivité et d'un quatrième transistor MOS (MN4) à canal du deuxième type de conductivité dans cet ordre entre le deuxième potentiel et le premier potentiel,
une connexion entre les grilles des premier et deuxième transistors et le point de raccordement des trajets drain-source des troisième et quatrième transistors, et
une connexion entre ladite entrée et les grilles des troisième et quatrième transistors.

2. Circuit de tirage selon la revendication 1, caractérisé en ce que le quatrième transistor est constitué de façon à avoir une résistance à l'état passant élevée par rapport à la résistance à l'état passant des autres transistors.

3. Circuit de tirage selon la revendication 1, caractérisé en ce que les premier, deuxième et troisième transistors sont des transistors MOS à canal P et le quatrième transistor est un transistor MOS à canal N, le premier potentiel étant un potentiel bas (Vss) et le deuxième potentiel un potentiel haut (Vdd).

4. Circuit de tirage selon la revendication 1, caractérisé en ce que les premier et deuxième transistors sont identiques.

## Patentansprüche

1. Schaltung zum Überführen eines Einganges (10) einer mit der Überführungsschaltung verbundenen integrierten Schaltung in Richtung auf einen zweiten Zustand, wobei die integrierte Schaltung sich entweder in einem ersten Zustand entsprechend einem ersten Potential (Vss) am Eingang, in einem zweiten Zustand entsprechend einem zweiten Potential (Vdd) am Eingang oder in einem dritten Zustand entsprechend einem gleitenden Potential am Eingang befinden kann, wobei die Überführungsschaltung folgende Merkmale aufweist:
einen ersten MOS-Transistor (MP1) mit einem Kanal eines ersten Leitungstypes, dessen Drain-Source-Strecke zwischen den genannten Eingang und das zweite Potential geschaltet ist,
eine Serienschaltung von Drain-Source-Strecken eines zweiten (MP2) und eines dritten MOS-Transistors (MP3) mit einem Kanal des ersten Leitungstypes, und einem vierten MOS-Transistor (MN4) mit einem Kanal des zweiten Leitungstypes, und zwar in dieser Reihenfolge zwischen dem zweiten Potential und dem ersten Potential,
eine Verbindung zwischen den Gate-Elektroden des ersten und zweiten Transistors und des Verbindungspunktes der Drain-Source-Strecken des dritten und vierten Transistors, und
eine Verbindung zwischen dem genannten Eingang und den Gate-Elektroden des dritten und vierten Transistors.

2. Überführungsschaltung nach Anspruch 1, dadurch gekennzeichnet, daß der vierte Transistor dergestalt ausgebildet ist, daß er einen erhöhten Widerstand im leitenden Zustand gegenüber dem Widerstand im leitenden Zustand der anderen Transistoren aufweist.

3. Überführungsschaltung nach Anspruch 1, dadurch gekennzeichnet, daß der erste, zweite und dritte Transistor jeweils ein MOS-Transistor mit einem P-Kanal und der vierte Transistor ein MOS-Transistor mit einem N-Kanal ist, und daß das erste Potential ein niedriges Potential (Vss) und das zweite Potential ein hohes Potential (Vdd) ist.

4. Überführungsschaltung nach Anspruch 1, dadurch gekennzeichnet, daß der erste und zweite Transistor gleich sind.

## Claims

1. A circuit for pulling to a second state an integrated circuit input (10) connected to the pulling circuit, the integrated circuit being capable of being in a first state corresponding to a first voltage (Vss) on the input, in a second state corresponding to a second voltage (Vdd) on the input, or in a third state corresponding to a floating voltage on the input, the pulling circuit comprising:
a first MOS transistor (MP1) with a channel of a first conductivity type the drain-source path of which is connected between said input and the second voltage,
the serial connection of the drain-source paths of a second (MP2) and third (MP3) MOS transistor with a channel of the first conductivity type, and of a fourth MOS transistor (MN4) having a channel of the second conductivity type, in this order between the second voltage and the first voltage,
a connection between the gates of the first and second transistors and the junction of the drain-source paths of the third and fourth transistors, and
a connection between said input and the gates of the third and fourth transistors.

2. The pulling circuit of claim 1, characterized in that the fourth transistor is designed so as to have a relatively high value resistance at the conductive state with respect to the resistances in the conductive state of the other transistors.

3. The pulling circuit of claim 1, characterized in that the first, second and third transistors are P-channel MOS transistors, and the fourth transistor is an N-channel MOS transistor, the first voltage being a low voltage (Vss) and the second voltage a high voltage (Vdd).

4. The pulling circuit of claim 1, characterized in that the first and second transistors are identical.
